# FASCICULE DE BREVET EUROPEEN

(11) **EP 3 465 755 B1**
(45) Date de publication et mention de la délivrance du brevet: **12.02.2025**
(21) Numéro de dépôt: 17730872.3
(22) Date de dépôt: 26.05.2017
(51) Int. Cl.: H01L 25/18, H01L 23/495, H01L 23/49, H03K 17/082, H03K 17/10, H03F 1/22, H03F 3/195

(54) **CIRCUIT INTÉGRÉ COMPRENANT UNE PUCE FORMÉE D'UN TRANSISTOR À HAUTE TENSION ET COMPRENANT UNE PUCE FORMÉE D'UN TRANSISTOR À BASSE TENSION**
INTEGRIERTE SCHALTUNG MIT EINEM DURCH EINEN HOCHSPANNUNGSTRANSISTOR GEBILDETEN CHIP UND MIT EINEM DURCH EINEN NIEDRIGSPANNUNGSTRANSISTOR GEBILDETEN CHIP
INTEGRATED CIRCUIT COMPRISING A CHIP FORMED BY A HIGH-VOLTAGE TRANSISTOR AND COMPRISING A CHIP FORMED BY A LOW-VOLTAGE TRANSISTOR

(30) Priorité: 26.05.2016 FR 1654715; 08.07.2016 FR 1656572
(43) Date de publication de la demande: 10.04.2019
(73) Titulaire: STMicroelectronics France, 92120 Montrouge (FR)
(72) Inventeur: MOREAU, Eric, 31470 Frouzins (FR); SUTTO, Thierry, 31600 Seysses (FR); GUILLOT, Laurent, 31600 Seysses (FR)
(74) Mandataire: Cabinet Beaumont
(86) Numéro de dépôt international: PCT/FR2017/051315
(87) Numéro de publication internationale: WO 2017/203186

(56) Documents cités:
- EP-A1- 2 955 844
- DE-A1- 102012 101 127
- US-A1- 2014 167 822
- US-A1- 2014 175 454
- US-A1- 2014 377 911
- US-B2- 8 624 662

## Description

### DOMAINE DE L'INVENTION

La présente invention concerne un circuit intégré comprenant une puce formée d'un transistor à haute tension et comprenant une puce formée d'un transistor à basse tension.

### ARRIERE PLAN TECHNOLOGIQUE DE L'INVENTION

Les transistors HEMT (transistors à haute mobilité électronique) élaborés sur des matériaux semi-conducteurs III-N sont classiquement « normally on », c'est-à-dire qu'ils présentent une tension de seuil négative et peuvent conduire le courant avec une tension entre la grille et la source de 0V. Ces composants avec tensions de seuil négatives sont appelés composants en mode déplétion (« depletion mode » ou « D-mode » selon la terminologie anglo-saxonne).

Il est préférable pour les applications d'électronique de puissance d'avoir des composants dits « normally off », c'est-à-dire présentant une tension de seuil positive qui ne peuvent donc pas conduire le courant lorsque la tension de grille est à 0 V. Ces composants sont communément appelés composants en mode enrichissement (« E-mode »).

La fabrication de composants à haute tension sur matériaux semi-conducteurs III-N en E-mode s'avère complexe et ces composants présentent souvent des performances intrinsèques moindres que les composants similaires en D-mode.

Une alternative à un composant E-mode haute tension simple est de combiner un composant D-mode à haute tension, tel qu'un transistor HEMT D-mode élaboré sur matériaux semi-conducteurs III-N, avec un composant E-mode basse tension, tel qu'un transistor MOSFET (Transistor métal/oxyde/semi-conducteur à effet de champ) E-mode élaboré sur silicium. Deux puces 1,2 comprenant respectivement les composants HEMT et MOSFET sont alors associées pour former un circuit intégré hybride 3, par exemple un circuit intégré de commutation.

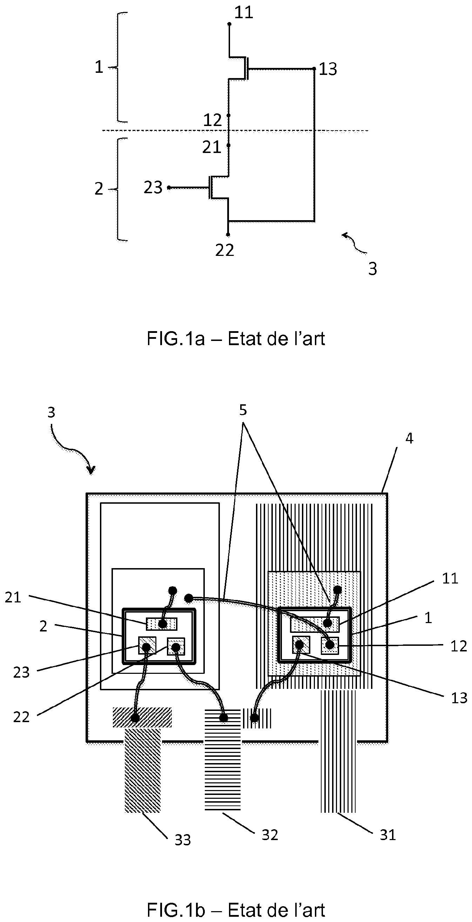

La figure 1a représente le schéma de principe d'un circuit hybride dit « en cascode » associant les composants HEMT et MOSFET. Un circuit intégré 3 mettant en œuvre cette première configuration est représenté sur la figure 1b. Le drain 21 et la source 22 d'une puce MOSFET E-mode 2 sont respectivement connectés à la source 12 et à la grille 13 d'une puce HEMT D-mode 1. Cette connexion électrique se fait dans le boitier 4 du circuit intégré 3 comprenant les deux puces électroniques 1,2, habituellement par connexion filaire 5 (« wire bonding » selon la terminologie anglo-saxonne) entre les plots de contact de grille 13,23, de source 12,22 et de drain 11,21 accessibles sur chacune des puces 1,2. Dans le circuit intégré cascode 3, la grille 23 de la puce MOSFET 2 contrôle la mise en mode passant ou bloquant du circuit intégré 3.

Le plot de contact de grille 23 de la puce MOSFET 2 est connecté dans le boitier 4 du circuit intégré 3 à une broche de grille 33. Le plot de contact de source 22 de la puce MOSFET 2 est connecté dans le boitier 4 à une broche de source 32. Enfin, le plot de contact de drain de la puce HEMT 1 est connecté, toujours dans le boitier 4, à une broche de drain 31. Les trois broches 31,32,33 constituent les connexions électriques du circuit intégré 3 à l'extérieur du boitier 4.

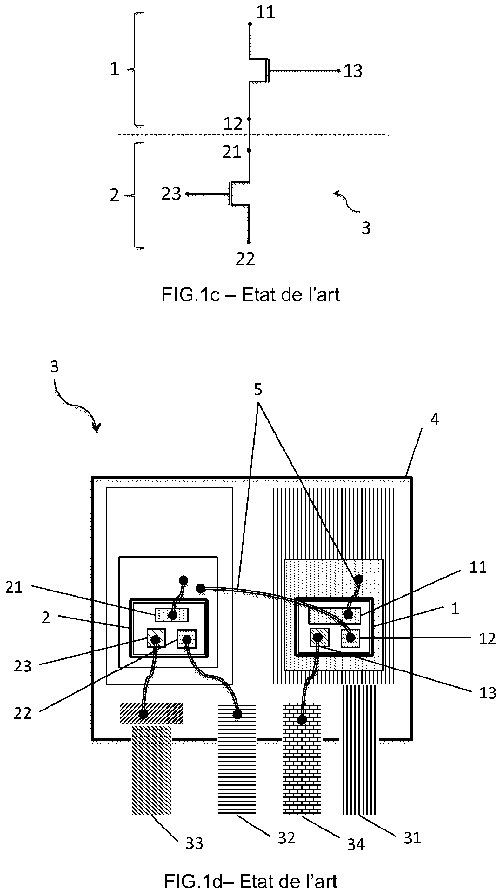

La figure 1c représente le schéma de principe d'un circuit hybride dit « en double commande » associant les composants HEMT et MOSFET. Un circuit intégré 3 mettant en œuvre cette deuxième configuration est représenté sur la figure 1d. Selon cette configuration alternative, les puces 1,2 comprenant respectivement les composants HEMT et MOSFET sont simplement connectés en série, le drain 21 de la puce MOSFET E-mode 2 étant connectée à la source 12 de la puce HEMT D-mode 1. Dans cette configuration, le boitier 4 du circuit intégré 3 dispose d'une broche de grille additionnelle 34, électriquement reliée au plot de contact de grille 13 de la puce HEMT D-mode 1 afin de permettre la commande directe de ce transistor.

Pour un exposé détaillé des principes de fonctionnement d'un circuit « cascode » ou d'un circuit « en double commande », on pourra se référer au document « A dual-mode Driver IC with Monolithic Negative Drive-Voltage Capability and Digital Current-Mode Controller for Depletion-Mode GaN HEMT », Yue Wen et Al, IEEE Transaction on Power Electronic, Issue 99, 1996.

Quelle que soit la configuration choisie, le circuit intégré 3 est destiné à être placé sur un circuit imprimé pour son interconnexion à d'autres composants.

Comme cela est bien connu en soit, par exemple de US92683512 ou de US8624662, il est usuel de placer, dans le circuit intégré 3, des composants additionnels, tels que des résistances ou des capacités, pour former un dispositif de protection. Ce dispositif de protection a pour fonction de mettre sous contrôle, notamment lors des phases transitoires de commutation, la tension (ou le courant) pouvant se développer (ou circuler) dans certains nœuds du circuit hybride.

La nature du dispositif de protection peut être dépendant de l'application envisagée (par exemple de la fréquence envisagée de commutation, de l'amplitude de la tension à commuter, etc.), ou de la nature des autres composants avec lesquels le circuit intégré 3 peut être relié sur le circuit imprimé.

Les circuits intégrés de l'état de la technique mettant en œuvre un circuit hybride n'offrent pas la possibilité d'ajuster la configuration du dispositif de protection qui sont préalablement prévus par le constructeur.

De plus, on pourrait souhaiter disposer d'un circuit intégré comprenant un composant E-mode haute tension et un composant D-mode basse tension, qui puisse être utilisé, selon le besoin, dans une configuration « cascode » ou dans une configuration « en double commande ».

Le document US 2014/175454 un dispositif de conversion de puissance pourvu de transistor à haute tension, équipé d'un boîtier et de plusieurs broches et de deux puces respectivement à transistor GaN et CMOS avec plots de contact entre les deux puces.

D'une manière plus générale, on ne dispose pas aujourd'hui de circuit intégré pour des applications dans le domaine de la commutation de puissance, comprenant un composant E-mode haute tension est un composant D-mode basse tension, qui soit versatile, simple de composition et robuste, c'est à dire qui puisse être utilisé dans une large gamme d'application (présentant des courants, tensions et des fréquences de commutation très variables) et d'environnement (notamment thermique ou électromagnétique) sans en modifier l'architecture interne.

### OBJET DE L'INVENTION

La présente invention vise à pallier tout ou partie des inconvénients précités.

### BREVE DESCRIPTION DE L'INVENTION

L'invention est définie par les revendications annexées.

### BREVE DESCRIPTION DES DESSINS

D'autres caractéristiques et avantages de l'invention ressortiront de la description détaillée de l'invention qui va suivre en référence aux figures annexées sur lesquels :
- les figures 1a et 1b représentent respectivement un schéma de principe et un circuit intégré d'un circuit cascode de l'état de la technique ;
- les figures 1c et 1d représentent respectivement un schéma de principe et un circuit intégré d'un circuit « en double commande » de l'état de la technique ;
- les figures 2a et 2b représentent respectivement un premier schéma de principe et un premier circuit intégré conforme à l'invention ;
- les figures 3a et 3b représentent respectivement un deuxième schéma de principe et un deuxième circuit intégré conforme à l'invention ;
- les figures 4a à 4c représentent différents modes de mise en œuvre d'un circuit intégré conforme à l'invention comportant un composant passif résistif de protection ;
- les figures 5a à 5c représentent un circuit intégré selon un autre aspect de l'invention.

### DESCRIPTION DETAILLEE DE L'INVENTION

Les figures ont un rôle illustratif uniquement et ne représentent pas les éléments à l'échelle. Par ailleurs, une même référence pourra être utilisée pour des éléments identiques ou remplissant les mêmes fonctions dans les différents modes de réalisation de l'invention ou dans l'état de la technique.

Divers exemples de mise en œuvre et de réalisation sont exposés par la suite. Indépendamment de la dénomination donnée à ces exemples (modes de réalisation, exemples, variantes, etc.) et des qualificatifs employés (par exemple, de préférence, etc.), seules les parties de description qui sont incluses dans la portée des revendications font partie de la présente invention, les autres exemples n'étant exposés qu'à titre illustratif et n'étant utiles que pour mettre en évidence des aspects spécifiques à l'invention par rapport à ce qui n'en fait pas partie.

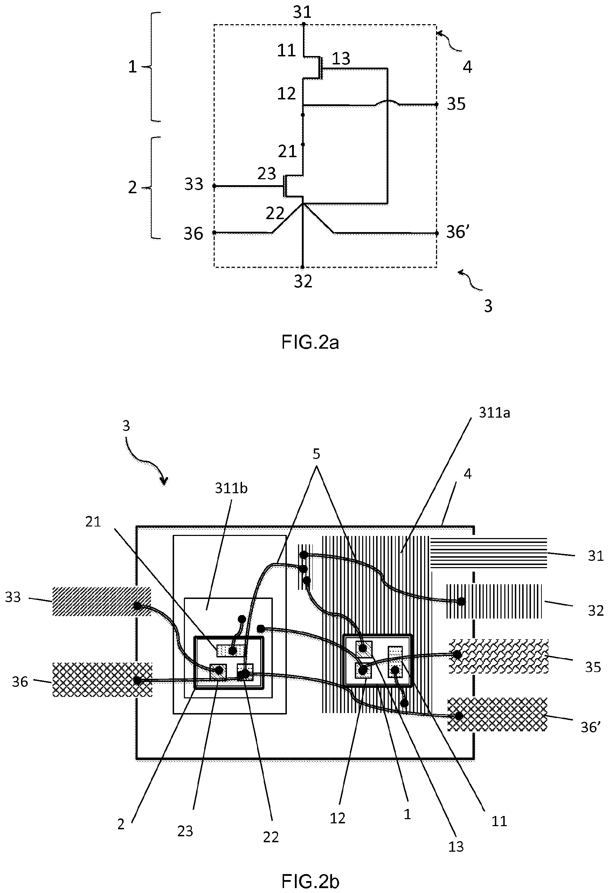

La figure 2a représente un schéma de principe d'un circuit intégré 3 conforme à l'invention. À l'intérieur d'un boîtier 4, représenté par les traits pointillés sur la figure 2a, un transistor haute tension en mode déplétion 1 (qui sera désigné par l'expression « transistor haute tension » dans la suite de cette description) et un transistor basse tension en mode enrichissement 2 (qui sera désigné par l'expression « transistor basse tension » dans la suite de cette description) sont connectés l'un à l'autre en configuration cascode. Plus précisément, la source 12 du transistor haute tension 1 est électriquement connecté au drain 21 du transistor basse tension 2. Cette connexion définit un nœud milieu du circuit. La grille 13 du transistor haute tension 1 est électriquement reliée à la source 22 du transistor basse tension 2.

Une pluralité de nœuds du circuit sont rendus accessibles à l'extérieur du boîtier 4 par l'intermédiaire de broches afin de pouvoir relier électriquement ce circuit à d'autres circuits.

On désignera par « broche », dans la suite de cette description, tout élément du circuit intégré 3 émergeant du boîtier 4 et permettant de donner un accès électrique à l'un des nœuds du circuit 3. Il peut ainsi s'agir d'un élément conducteur saillant du boîtier 4 ou d'une simple surface de contact disposée sur l'une des faces du boîtier 4**.**

Comme cela est représenté sur le schéma de principe de la figure 2a, le circuit 3 comportent une broche de grille 33, une broche de source 32, respectivement électriquement connectées à la grille 23 et à la source 22 du transistor basse tension 2. Ce circuit comporte également une broche de drain 31 électriquement connectée au drain 11 du transistor haute tension 1 et une broche de point milieu 35 permettant de donner un accès électrique au nœud milieu du circuit 3.

Le circuit 3 de la figure 2a peut être utilisé comme commutateur de puissance. À cet effet, la broche de source 32 est reliée à une masse électrique, la broche de drain 31 est reliée à une charge. La commutation du circuit 3 est commandée par un signal de commande appliqué sur la broche de grille 33. Lorsque le signal de commande présente une tension nulle, le circuit 3 est bloquant. Lorsque le signal de commande présente une tension positive (typiquement de quelques volts) le circuit 3 est passant. Plusieurs ampères peuvent alors circuler entre la broche de drain 31 et la broche de source 32 du circuit 3.

Comme cela a été préalablement évoqué dans l'introduction de cette demande, la commutation du circuit 3 entre un état passant et un état bloquant (ou inversement entre un état bloquant et un état passant) peut conduire à l'apparition de courants ou de tensions non contrôlés dans le circuit, notamment au nœud milieu. Ces tensions ou ces courants transitoires peuvent endommager les transistors haute tension 1 et basse tension 2 s'ils dépassent des seuils prédéfinis.

Afin de se prémunir de ces phénomènes, le dispositif de la présente description permet de placer, en dehors du boitier 4, un circuit de contre-mesures entre la broche de point milieu 35 et la broche de source 32. Il peut par exemple s'agir d'un circuit comprenant une résistance, éventuellement complétée d'une capacité parallèle, disposé entre les broches précitées 35, 32. Le circuit de contre-mesures permet notamment de limiter la tension transitoire se développant au nœud milieu, et de dériver le courant statique ou transitoire excessif qui pourrait circuler dans le transistor basse tension 2 pendant ces phases de commutation.

Lorsque la fréquence de commutation du signal de commande est importante, par exemple supérieure à 100 kHz, les liaisons électriques internes du circuit (par exemple les liaisons électriques reliant les électrodes des transistors haute et basse tension 1, 2 aux broches du boîtier 4) peuvent présenter un comportement inductif. Les variations brusques du courant circulant dans ces liaisons conduisent à la génération d'une tension transitoire importante à leurs bornes. C'est notamment le cas pour la liaison reliant la source 22 du transistor basse tension 2 et la broche de source 32 du circuit. Afin d'éviter d'injecter ces courants et tensions transitoires du côté du circuit de commande, qui peut être relié aux broches de grille 33 et de source 32, ou du côté du circuit de contre-mesures qui peut être relié aux broches de point milieu 35 et de source 32, le circuit prévoit une première broche kelvin 36 électriquement reliée à la source 22 du transistor basse tension 2 par une connexion kelvin.

Comme cela est bien connu en soi, une connexion kelvin, ou connexion de détection de tension, est destinée à être reliée à un circuit présentant une très forte impédance en régime établi, si bien que le courant circulant à travers cette connexion est extrêmement faible. Sur la broche kelvin 36 du boitier 4, on dispose donc d'une mesure de la tension présente au niveau de la source 22 du transistor basse tension 2. Le courant circulant dans la liaison reliant la source 22 à la broche kelvin 36 étant très faible, la mesure de tension n'est pas perturbée par des tensions inductives.

La broche kelvin 36 peut être connectée à un circuit de commande externe au boitier, le circuit de commande étant lui-même connecté à la broche de grille 33. En complément, la broche kelvin 36 peut être connectée au circuit de contre-mesures externe au boitier, le circuit de contre mesure étant lui-même connecté à la broche de point milieu 35. La disponibilité conjointe de la tension au point milieu au niveau de la broche de point milieu 35 et de la broche kelvin 36, offre la possibilité de former un dispositif de contre-mesure très adapté à l'environnement dans lequel le circuit intégré 3 est placé.

Afin de permettre un montage aisé du circuit intégré 3 sur un circuit imprimé, faciliter la configuration ou le routage des pistes conductrices sur ce circuit et minimiser les boucles de contrôle, on peut choisir de disposer, sur le boîtier 4, la première broche kelvin 36 adjacente à la broche de grille 33 ou disposée sur un même coté du boitier que la broche de grille 33 (comme cela est représenté sur la figure 2a), ou adjacente à la broche de point milieu 35 ou disposée sur un même coté du boitier que la broche de point milieu 35.

Selon l'invention revendiquée, on munit le circuit 3 d'une première broche kelvin 36 et d'une seconde broche kelvin 36', qui peuvent toutes deux être de constitutions similaires. On peut dans ce cas disposer, sur le boîtier 4, la première broche kelvin 36 adjacent à la broche de grille 33 (ou disposée sur un même coté du boitier que la broche de grille 33) et la seconde broche kelvin 36' adjacente à la broche de point milieu 35 (ou disposée sur un même coté du boitier que la broche de point milieu 35).

La figure 2b présente un mode de réalisation, sous la forme d'un circuit intégré 3, du circuit schématique représenté sur la figure 2a.

Le circuit intégré 3 comportent un boîtier 4, une première puce 1 comprenant un transistor haute tension en mode déplétion et une deuxième puce 2 comprenant un transistor à basse tension en mode enrichissement. La première et la seconde puce 1, 2 comportent respectivement des plots de contact de grille 13, 23, des plots de contact de drain 11, 21 et des plots de contact de source 12, 22. Avantageusement, le transistor haute tension est un transistor HEMT élaboré sur matériaux semi-conducteurs III-N et le transistor basse tension est un transistor MOSFET (Transistor métal/oxyde/semi-conducteur à effet de champ) élaboré sur silicium.

Les plots de contact de drain 11, 21 de la première puce 1 et de la deuxième puce 2 sont respectivement connectés à des plaques de contact 311a, 311b soit par une connexion filaire (comme représenté sur la figure 2b), soit par une connexion verticale présentant un contact de drain au niveau de la face arrière de la première et/ou de la deuxième puce 1, 2 en contact avec les plaques 311a, 311b.

La plaque de contact 311b forme une borne électrique à laquelle le plot de contact de la source 12 de la première puce 1 est électriquement relié, et constitue le point milieu du circuit 3. La plaque de contact 311b est électriquement connectée à la broche de point milieu 35 du circuit intégré 3. La deuxième plaque de contact 311a est quant à elle électriquement connectée à (ou constitue) la broche de drain 31 du circuit intégré 3.

Le plot de contact de grille 13 de la première puce 1 est connectée au plot de contact de source 22 de la deuxième puce 2. On forme de la sorte un circuit cascode. Ces plots de contacts 13, 22 sont eux même reliés à la broche de source 32.

La broche de grille 33 du circuit 3 est connectée au plot de contact de grille 23 de la deuxième puce 2.

Conformément à l'invention revendiquée, le boîtier 4 du circuit intégré 3 comprend une première et une seconde broche kelvin 36, 36'. La première broche kelvin 36 et la seconde broche kelvin 36' sont reliées électriquement au plot de contact de source 22 du transistor à basse tension formé sur la deuxième puce 2.

Comme on l'a vu précédemment, la première broche kelvin 36 peut-être disposée, sur le boitier 4, adjacente à, ou sur un même coté du boitier 4, que la broche de grille 33 La seconde broche kelvin 36' peut être disposée, sur le boitier 4, adjacente à la broche de point milieu 35 (ou sur un même coté du boitier 4 que cette broche).

Par ailleurs, la broche de point milieu 35 peut-être disposée adjacente à la broche de source 32 pour faciliter l'implantation du circuit de contre-mesure sur le circuit imprimé.

Comme cela est représenté sur la figure 2b, les connexions ou liaisons électriques sont formées (ou comprennent) de connexions filaires 5. Bien que cela ne soit pas représenté sur les figures, ces liaisons ou connexions électriques peuvent également comprendre des éléments passifs, tels que des résistances ou des diodes, qui peuvent être par exemple être intégrés dans l'une des première et deuxième puces 1,2 ou sur une puce complémentaire placée dans le boîtier.

Le boîtier 4 peut également comprendre des circuits additionnels intégrés à l'une des puces 1 ou 2, ou dans la puce complémentaire. Il peut s'agir par exemple d'un circuit de commande de la grille.

Ainsi, on peut munir le circuit intégré 3 d'un composant passif résistif 9 disposé dans le boitier 4 et connecté électriquement entre le plot de contact de grille 23 du transistor basse tension (également appelé deuxième plot de contact de grille 23) et le plot de contact de source 22 du transistor basse tension (également appelé deuxième plot de contact de source 22).

On contient de la sorte les potentielles défaillances de connexion de grille qui conduiraient à mettre celle-ci à un potentiel flottant et à perdre le contrôle du circuit intégré fonctionnant en tant que commutateur de forte puissance. La présence du composant passif résistif 9, au plus proche de la deuxième puce électronique 2 dont la grille 23 commande le mode passant ou bloquant du circuit intégré 3, permet de ramener le potentiel de la grille 23, s'il est flottant, au potentiel de source (c'est-à-dire à un potentiel proche de 0) et ainsi de basculer en mode bloquant s'il y a perte de contrôle du potentiel de grille. Les défaillances survenant au niveau du circuit imprimé (coupure d'une piste PCB par exemple) sont contenues, ainsi que celles survenant entre le circuit intégré 3 et le circuit imprimé (décrochage d'une broche par exemple). On forme ainsi un circuit particulièrement robuste et sécurisé, capable de contenir des défaillances pour répondre aux normes de sureté de fonctionnement établies.

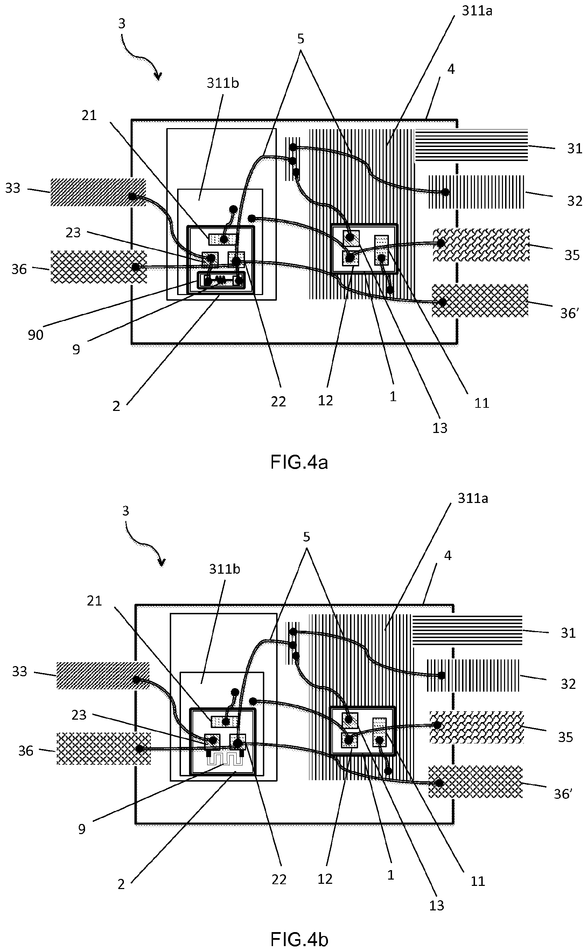

La figure 4a représente un premier mode de mise en œuvre d'un circuit intégré 3 comprenant un composant passif résistif 9 disposé dans le boitier 4 et connecté électriquement entre le deuxième plot de contact de grille 23 et le deuxième plot de contact de source 22. Le composant passif résistif 9 est formé dans une troisième puce 90 reliée électriquement à la deuxième puce 2 par connexion filaire 5. Deux connexions filaires sont ajoutées par rapport à la configuration classique pour relier d'une part, le deuxième plot de contact de grille 23 (de la deuxième puce 2), à un plot de contact de la troisième puce 90 et d'autre part, le deuxième plot de contact de source 22 (de la deuxième puce 2) à un autre plot de contact de la troisième puce 90.

La figure 4b représente un deuxième mode de mise en œuvre d'un circuit intégré 3 comprenant un composant passif résistif 9 intégré dans la deuxième puce 2. Cette configuration est très avantageuse en ce qu'elle ne rajoute pas de complexité dans le montage du circuit intégré 3 car aucune connexion filaire supplémentaire n'est requise. Le composant passif résistif 9 peut être réalisé au cours de l'élaboration du transistor basse tension inclus dans la deuxième puce 2, en technologie semiconducteur, au niveau du substrat (« wafer level ») avant singularisation de la puce 2. La connexion du composant résistif 9 entre le deuxième plot de contact de grille 23 et celui de source 22 peut ainsi être effectuée dans la couche d'interconnexions métalliques, au niveau du substrat. Le composant passif résistif 9 pourra par exemple être formé par un serpentin métallique dont les extrémités sont respectivement connectées aux plots 23 et 22.

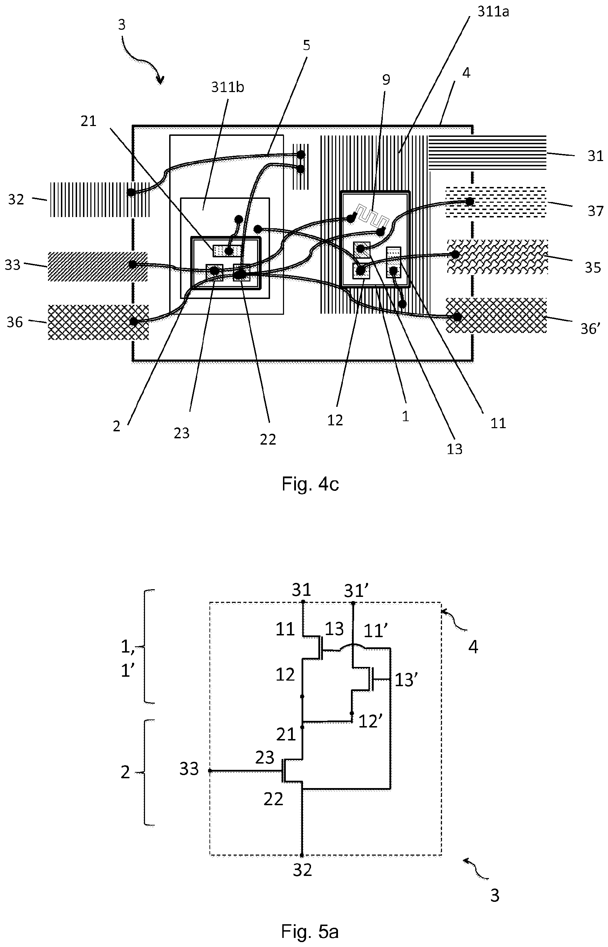

La figure 4c représente un troisième mode de mise en œuvre d'un circuit intégré 3 comprenant un composant passif résistif 9 intégré dans la première puce 1. Deux connexions filaires 5 sont ajoutées par rapport à la configuration classique pour relier d'une part, le deuxième plot de contact de grille 23 (de la deuxième puce 2), à un plot de contact de la résistance 9 de la première puce 1 et d'autre part, le deuxième plot de contact de source 22 (de la deuxième puce 2) à un autre plot de contact de la résistance 9.

Dans le cas où la première puce 1 est à base de matériaux III-N, le transistor à haute tension fonctionnant avec un canal de conduction formé dans une couche de gaz électronique à 2 dimensions (Couche 2DEG), la résistance 9 pourra être avantageusement formée par un segment de ladite couche 2DEG, connecté à ses deux extrémités à des plots de contact.

Dans tous ces modes de mise en œuvre, le composant passif 9 présente avantageusement une résistance supérieure à 100 kilo-ohms. Cette valeur élevée de résistance est requise pour limiter le courant de fuite entre la grille et la source, en mode passant du circuit intégré 3. En considérant une différence de potentiel de l'ordre de 10 Volts entre grille et source, le courant de fuite est estimé à 100 micro-Ampère, ce qui est acceptable, notamment pour des applications de commutation de fortes puissances (650 V - 10 A).

La valeur de la résistance du composant passif 9 est préférablement choisie inférieure à 1 méga-ohm, pour conserver un temps de réaction en cas de défaillance, acceptable et répondant aux normes de sécurité. En effet, le temps de basculement en mode bloquant, c'est-à-dire le temps que mettra le potentiel de grille flottant à revenir au potentiel de source, est défini par la constante de temps τ=RC. R est la résistance entre grille et source, principalement constituée par la résistance de composant passif 9 ; C est la capacité entre grille et source. En considérant que la capacité C est de l'ordre de 100 picofarad dans un composant MOSFET de 30V et que la constante de temps est attendue inférieure ou égale à 100 microsecondes, la résistance du composant passif 9 doit préférablement rester inférieure à 1 méga-ohm.

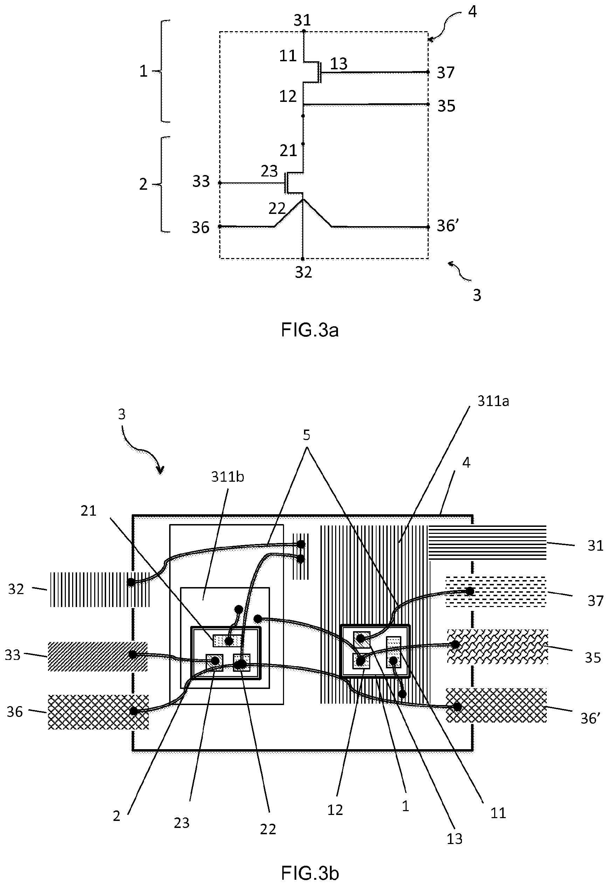

La figure 3a représente un autre schéma de principe d'un circuit 3 conforme à l'invention.

Contrairement au schéma de principe du circuit intégré 3 de la figure 2a, la source 22 du transistor basse tension 2 n'est pas électriquement reliée à la grille 13 du transistor haute tension 1 à l'intérieur du boîtier 4. La grille 13 du transistor haute tension 1 est, par contre, électriquement connectée à une seconde broche de grille 37 du boîtier 4.

Les autres éléments du circuit 3 sur cette figure 3a sont identiques à ceux du circuit de la figure 2a, et leur description sera donc omise par souci de concision.

Le circuit 3 de la figure 3a peut être utilisé pour former un circuit cascode. Il suffit pour cela de connecter, à l'extérieur du boîtier 4, par exemple par l'intermédiaire d'une piste conductrice d'un circuit imprimé sur lequel le circuit 3 est disposé, la broche de source 32 à la seconde broche de grille 37.

Le circuit 3 de la figure 3a peut être également utilisé en double commande. Dans ce cas, un premier circuit de commande peut être connecté à la première broche de grille 33, et un second circuit de commande (ou une sortie additionnelle du premier circuit de commande) connecté à la seconde broche de grille 37.

Avantageusement, le circuit de commande associé à la seconde broche de grille 37 est un circuit de commande différentiel, connectée d'une part à la broche de grille 37 et d'autre part à la broche de point milieu 35 du circuit intégré 3. Cette configuration permet d'imposer une tension différentielle entre la grille 13 et la source 12 du transistor haute tension en mode déplétion 1. Une tension différentielle négative permet de bloquer ce transistor, et donc de rendre bloquant le circuit intégré 3.

Le circuit de commande associée à la première broche de grille 33 agit dans ce cas comme une commande de sécurité permettant d'assurer le blocage du circuit 3 lors des phases de mise sous tension ou d'extinction du circuit 3 et des circuits périphériques pendant lesquelles l'état bloqué du transistor haute tension ne peut pas être assuré.

La figure 3b représente un mode de réalisation, sous la forme d'un circuit intégré 3, du circuit schématique représenté sur la figure 3a.

Le circuit intégré 3 dispose d'une deuxième broche de grille 37. Celle-ci est électriquement reliée au plot de contact de grille 13 du transistor haute tension de la première puce 1.

Dans le circuit intégré 3 de la figure 3b, le plot de contact de grille 13 du transistor haute tension de la première puce 1 n'est pas électriquement reliée à l'intérieur du boîtier au plot de contact de source 22 de la deuxième puce 2. Les autres éléments et avantages du circuit intégré 3 représenté sur cette figure sont identiques à ceux du circuit intégré de la figure 2b, et leur description sera donc omise par souci de concision.

Similairement à ce qui avait été énoncé pour le circuit intégré de la figure 2b, le boîtier 4 peut également comprendre des circuits ou des composants additionnels, tel qu'un composant passif résistif 9. Ceux-ci peuvent être intégrés à la première puce 1 ou à la deuxième puce 2, ou être disposés sur une puce complémentaire placée dans le boîtier 4, comme cela a été rendu explicite dans les trois modes de mise en œuvre détaillés précédemment.

La figure 5a représente un schéma de principe d'un autre circuit intégré 3 conforme à un autre aspect de l'invention.

À l'intérieur d'un boîtier 4 représenté par des traits pointillés sur cette figure, un transistor basse tension 2 est connecté en configuration cascode à deux transistors haute tension 1, 1', eux-mêmes connectés en parallèle l'un de l'autre. Plus précisément, les sources 12, 12' des transistors haute tension 1, 1' sont toutes deux électriquement connectées au drain 21 du transistor basse tension 2. On définit de la sorte, similairement aux configurations présentées précédemment, un point milieu du circuit. Les grilles 13, 13' des transistors haute tension 1, 1' sont électriquement reliées à la source 22 du transistor basse tension 2.

Cette configuration peut être généralisée à plus de deux transistors haute tension 1, 1', ces transistors étant tous placés en parallèle les uns des autres, leurs sources électriquement connectées au drain 21 du transistor basse tension 2, et leurs grilles étant électriquement connectées à la source 22 du transistor basse tension 2.

Les transistors haute tension 1, 1' présentent des tensions de seuil Vt identiques ou similaires.

De manière surprenante, les inventeurs de la présente demande ont observé que même lorsque les transistors haute tension 1, 1' ne présentait pas de caractéristiques exactement identiques (ce qui est très difficile à obtenir car des composants, même issus d'un même lot de fabrication, peuvent toujours présenter de très légères différences), la configuration cascode représentée à la figure 5a reste parfaitement fonctionnelle. De préférence toutefois, on choisira les transistors haute tension 1, 1' pour qu'ils présentent une tension seuil Vt comprise dans un intervalle de plus ou moins 10% de leurs tensions seuil moyenne.

Cette configuration contribue à rendre le circuit intégré 3 très versatile, c'est-à-dire qu'il peut être adapté à une très large gamme d'applications. On peut notamment relier, sur un circuit imprimé, un nombre choisi de transistors haute tension 1, 1' du circuit intégré 3 selon l'intensité attendue du courant dans l'application. Pour une intensité de courant importante, on pourra par exemple choisir de connecter les deux drains 11, 11' des transistors haute tension 1, 1' à la charge, de manière à répartir le courant dans les deux transistors. Cela conduit à un comportement thermique du circuit intégré 2 très favorable, comparé à un circuit intégré dans lequel tout le courant circule dans un unique transistor haute tension. L'échauffement des puces 1, 1' est en effet moindre et, surtout, réparti sur une plus grande surface ce qui favorise doublement sa dissipation.

Le boîtier 4 selon cet aspect de l'invention est avantageusement muni d'une pluralité de broches de drain 31, 31', électriquement isolées les unes des autres, chaque broche de drain étant reliée électriquement à un drain 11, 11' d'un transistor haute tension 1, 1'. Cette configuration de brochage permet de relier le circuit intégré 3 au reste des composants d'un circuit imprimé, dans un schéma électrique ou un nombre choisi de puces haute tension 1, 1' peut être utilisé. Cette configuration permet également de tester séparément la fonctionnalité de chacune des puces haute tension 1, 1' du circuit intégré à l'issue de sa fabrication, ce qui ne serait pas le cas si une unique broche de drain 31 était électriquement reliées aux drains 11, 11' des transistors haute tension 1, 1'.

Avantageusement, les premières puces 1, 1' comprennent des transistors HEMT élaborés à partir de matériaux III-N et le transistor basse tension 2 est un transistor MOSFET élaboré sur silicium.

Le circuit intégré 3 comporte également une broche de grille 33, de source 32 respectivement connectées à la grille 23 et à la source 22 du transistor haute tension 2.

Le circuit intégré 3 est également entièrement compatible avec toutes les caractéristiques du circuit intégré 3 exposées précédemment en relation avec les figures 2b, 3b et 4a à 4c. Bien que cela ne soit pas représenté sur la figure 5a, on prévoit une broche de point milieu, une première et une seconde broche Kelvin permettant de composer à l'extérieur du boîtier 4 un circuit de commande ou de contre-mesures adapté à l'environnement applicatifs particuliers dans lequel le circuit 3 est employé. Pour faciliter la réalisation de ces montages, les broches Kelvin peuvent être respectivement placées adjacentes à, ou disposées du même côté du boîtier que, la broche de grille 33 ; ou adjacente à, ou disposées du même côté du boîtier que, la broche de point milieu.

On peut prévoir également de placer dans le boitier 4 d'autres composants, tel qu'un composant passif résistif, similairement à ce qui a été décrit précédemment.

De même, plutôt que de former le circuit cascode directement à l'intérieur du boîtier en reliant la source 22 du transistor basse tension 2 aux grilles 13, 13' des transistors haute tension 1, 1', on peut préférer connecter électriquement les grilles 13, 13' à des broches libres du boîtier 4 et former ainsi un circuit cascade disposant d'une pluralité de broches de grilles, permettant de contrôler séparément les transistors haute tension et basse tension.

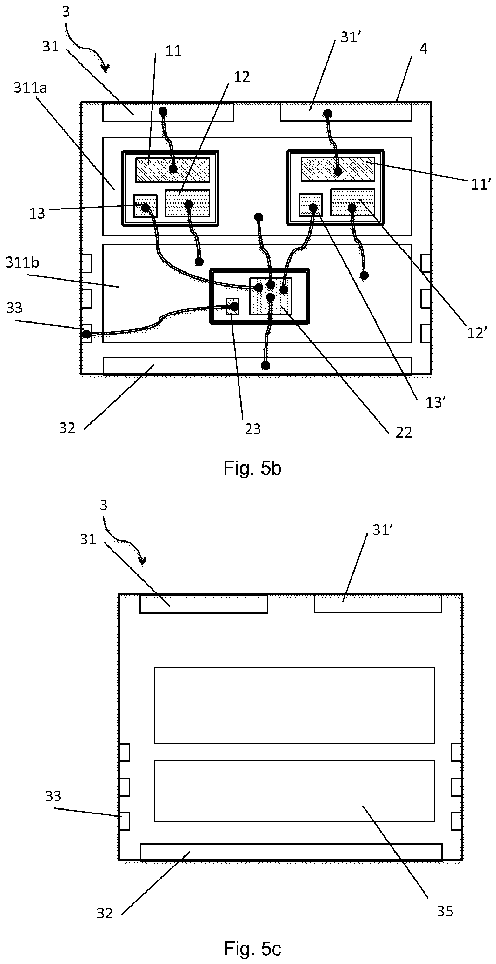

Les figures 5b et 5c représente un mode particulier de réalisation du circuit représenté sur la figure 5a.

On retrouve, dans un boîtier 4, une pluralité de premières puces 1, 1' comprenant chacune un transistor haute tension en mode déplétion et une deuxième puce 2 comprenant un transistor à basse tension en mode enrichissement. Les premières puces 1, 1' et la deuxième puce 2 comportent respectivement des plots de contact de grille 13, 13', 23, des plots de contact de drain 11, 11', 21 et des plots de contact de source 12, 12', 22.

Sur la figure 5b, le deuxième plot de contact de drain 21 est placé sur la face arrière de la deuxième puce 2 et mis en contact électrique avec une deuxième plaque de contact 311b. Les premières puces 1, 1' sont quant à elles disposées sur une première plaque de contact 311a sans que celle-ci ne soit reliée à un quelconque plot de contact de ces premières puces 1, 1'. La première plaque de contact 311a et la deuxième plaque de contact 311b sont électriquement isolées l'une de l'autre.

La première plaque de contact 311a peut former une masse électrique du circuit intégré. À cet effet, le deuxième plot de contact de source 22 de la deuxième puce 2 peut être électriquement relié à la plaque de contact 311a.

Dans le cas du circuit 3 représenté sur la figure 5b, les broches sont constituées de simple surface de contact pour un montage « en surface » du circuit intégré 3 (« Surface Mount Package » selon la terminologie anglo-saxonne employée). Ces surfaces de contact formant les broches peuvent être aménagées sur la face arrière du boîtier 4, le long des côtés de cette face ou sur sa partie centrale. On pourrait bien entendu envisager d'employer une autre technologie de brochage.

Les plots de contact de grille 13, 13' des premières puces 1, 1' sont reliés au plot de contact de source 22 de la deuxième puce 2 pour former un circuit cascode. Le plot de contact de source 22 est lui-même relié à la broche de source 32, la broche de grille 33 est connectée au deuxième plot de contact de grille 23 de la deuxième puce 2.

La deuxième plaque de contact 311b est reliée électriquement aux plots de contact de source 12, 12' des premières puces 1, 1' et les plots de contact de drain 11, 11' des premières puces 1, 1' reliées électriquement aux broches de drain 31, 31' du circuit 3.

Les liaisons et connexions électriques à l'intérieur du boîtier 4 peuvent être formées par des connexions filaires. Le boîtier 4 peut être muni sur sa face arrière d'ouverture permettant d'exposer les première et deuxième plaques de contact 311a, 311b afin de constituer des broches additionnelles sous la forme de surfaces centrales de contact, comme cela a été évoqué précédemment.

On a ainsi représenté sur la figure 5c une vue de la face arrière du circuit intégré 3. Sur cette vue, on observe la broche de grille 33, de source 32, et les broches de drain 31, 31' du circuit 3 sur les côtés de la face arrière du boîtier 4. Des ouvertures centrales formées sur ce boîtier 4 expose les plaques de contact 311a, 311b formant alors respectivement des broches de masse, et de point milieu 35 du circuit intégré 3.

Les broches non employées du circuit 3 peuvent être utilisées par exemple pour former les broches de connexion kelvin, ou pour reporter les plots de grille 13, 13' des puces à haute tension 1, 1' dans le cas où l'on préfère configurer le circuit 3 en circuit cascade.

L'invention propose donc un circuit intégré 3 pouvant avoir une fonction de commutation de puissance et pouvant présenter une broche de point milieu 35 donnant accès à un nœud milieu du circuit. Il est muni de broches Kelvin 36, 36' et comporte une pluralité de premières puces haute tension, ce qui permet de gérer au mieux son échauffement. Ce circuit intégré 3 présente l'avantage d'être très polyvalent, c'est-à-dire qu'il peut se combiner avec d'autres circuits (de commandes ou de contre-mesures) pour une large gamme d'application, la combinaison de ces caractéristiques permettant de configurer ces circuits additionnels aux particularités (fréquence, amplitude des signaux, phases transitoires, intensité de courant...) de l'application.

## Revendications

1. Circuit intégré (3) comprenant un boîtier (4) et une pluralité de broches de connexion, une première puce (1) comprenant un transistor à haute tension en mode déplétion et une deuxième puce (2) comprenant un transistor à basse tension en mode enrichissement, la première et la deuxième puce comportant respectivement des plots de contact de grille (13, 23), de drain (11, 21) et de source (12, 22) ; le plot de contact de source (12) du transistor à haute tension étant relié électriquement au plot de contact de drain (21) du transistor à basse tension pour former ainsi un nœud milieu du circuit, le circuit intégré comprenant une première broche kelvin (36) électriquement reliée au plot de contact de source (22) du transistor à basse tension, le circuit intégré comprenant une broche de point milieu (35) électriquement reliée au nœud milieu du circuit, le circuit intégré comportant de plus une broche de drain (31) électriquement relié au plot de contact de drain (11) du transistor à haute tension, une broche de source (32) électriquement reliée au plot de contact de source (22) du transistor à basse tension, une broche de grille (33) électriquement reliée au plot de contact de grille (23) du transistor à basse tension, le circuit intégré étant **caractérisé en ce qu'**il comprend de plus une seconde broche kelvin (36') électriquement reliée au plot de contact de source (22) du transistor à basse tension.

2. Circuit intégré selon la revendication 1 dans lequel la première broche kelvin (36) est adjacente à la broche de grille (33) ou disposée sur un même coté du boitier que la broche de grille (33) et la seconde branche kelvin (36') est adjacente à la broche de point milieu (35) ou disposée sur un même coté du boitier (4) que la broche de point milieu (35) .

3. Circuit intégré (3) selon la revendication 1 ou 2 dans lequel la broche de point milieu (35) est adjacente à la broche de source (32).

4. Circuit intégré (3) selon l'une des revendications précédentes comprenant une seconde broche de grille (37) électriquement reliée au plot de contact de grille (13) du transistor haute tension.

5. Circuit intégré (3) selon la revendication précédente dans lequel la seconde broche de grille (37) est adjacente à la broche de point milieu (35).

6. Circuit intégré (3) selon l'une des revendications 1, 2 et 3 dans lequel le plot de contact de source (22) du transistor basse tension est électriquement relié au plot de contact de grille (13) du transistor haute tension.

7. Circuit intégré (3) selon l'une des revendications précédentes dans lequel des liaisons électriques sont constituées de connexions filaires (5).

8. Circuit intégré (3) selon l'une des revendications précédentes comprenant un composant passif résistif (9) disposé dans le boitier (4) et connecté électriquement entre le plot de contact de grille (23) de la deuxième puce (2) et le plot de contact de source (22) de la deuxième puce (2).

9. Circuit intégré (3) selon la revendication précédente, dans lequel le composant passif résistif (9) est formé dans une troisième puce (90) reliée électriquement à la deuxième puce (2) par connexion filaire (5).

10. Circuit intégré (3) selon la revendication 9, dans lequel le composant passif résistif (9) est formé dans la deuxième puce (2) ou dans la première puce (1).

11. Circuit intégré (3) selon la revendication 9 ou 10, dans lequel le composant passif résistif (9) présente une résistance comprise entre 100 kilo-ohms et 1 méga-ohm.

12. Circuit intégré (3) selon l'une des revendications précédentes dans lequel la première puce comporte une pluralité de puces (1, 1') comprenant chacune un transistor haute tension en mode déplétion et connectées en parallèle les unes avec les autres.

13. Circuit intégré (3) selon la revendication précédente comprenant une pluralité de broches de drain (31, 31'), chaque broche de drain étant reliée électriquement à un plot de contact de drain (11, 11') d'une puce (1, 1') de la première puce.

## Patentansprüche

1. Integrierte Schaltung (3) aufweisend ein Paket (4) und eine Vielzahl von Anschlusspins, einen ersten Chip (1) aufweisend einen Hochspannungstransistor im Verarmungsmodus, und aufweisend einen zweiten Chip (2) aufweisend einen Niederspannungstransistor im Anreicherungsmodus, wobei der erste und der zweite Chip jeweils Gate- (13, 23), Drain- (11, 21) und Source- (12, 22) Kontaktpads aufweisen; wobei das Source-Kontaktpad (12) des Hochspannungstransistors elektrisch mit dem Drain-Kontaktpad (21) des Niederspannungstransistors gekoppelt ist, um so einen mittleren Knoten der Schaltung zu bilden, wobei die integrierte Schaltung einen ersten Kelvin- Pin (36) aufweist, der elektrisch mit dem Source-Kontaktpad (22) des Niederspannungstransistors gekoppelt ist, wobei die integrierte Schaltung einen Mittelpunkt-Pin (35) aufweist, der elektrisch mit dem mittleren Knoten der Schaltung gekoppelt ist, wobei die integrierte Schaltung ferner einen Drain- Pin (31) aufweist, der elektrisch mit einem Drain- Kontaktpad (11) des Hochspannungstransistors gekoppelt ist, einen Source- Pin (32), der elektrisch mit dem Source- Kontaktpad (22) des Niederspannungstransistors gekoppelt ist, einen Gate- Pin (33), der elektrisch mit dem Gate- Kontaktpad (23) des Niederspannungstransistors gekoppelt ist, wobei die integrierte Schaltung **dadurch gekennzeichnet ist, dass** sie ferner einen zweiten Kelvin- Pin (36') aufweist, der elektrisch mit dem Source- Kontaktpad (22) des Niederspannungstransistors gekoppelt ist.

2. Integrierte Schaltung nach Anspruch 1, wobei der erste Kelvin- Pin (36) benachbart zum Gate- Pin (33) ist, oder auf der gleichen Seite des Pakets wie der Gate- Pin (33) angeordnet ist, und wobei der zweite Kelvin- Pin (36') benachbart zum Mittelpunkt- Pin (35) ist, oder auf der gleichen Seite des Pakets (4) wie der Mittelpunkt- Pin (35) angeordnet ist.

3. Integrierte Schaltung (3) nach Anspruch 1 oder 2, wobei der Mittelpunkt-Pin (35) benachbart zu dem Source-Pin (32) ist.

4. Integrierte Schaltung (3) nach einem der vorhergehenden Ansprüche, aufweisend einen zweiten Gate-Pin (37), der elektrisch mit dem Gate-Kontaktpad (13) des Hochspannungstransistors gekoppelt ist.

5. Integrierte Schaltung (3) nach dem vorhergehenden Anspruch, wobei der zweite Gate- Pin (37) benachbart zu dem Mittelpunkt-Pin (35) ist.

6. Integrierte Schaltung (3) nach einem der Ansprüche 1, 2 und 3, wobei das Source-Kontaktpad (22) des Niederspannungstransistors elektrisch mit dem Gate-Kontaktpad (13) des Hochspannungstransistors gekoppelt ist.

7. Integrierte Schaltung (3) nach einem der vorhergehenden Ansprüche, wobei die elektrische Kopplung aus Drahtverbindungen (5) besteht.

8. Integrierte Schaltung (3) nach einem der vorhergehenden Ansprüche, aufweisend ein passives resistives Bauelement (9), das in dem Paket (4) angeordnet und elektrisch zwischen dem Gate-Kontaktpad (23) des zweiten Chips (2) und dem Source-Kontaktpad (22) des zweiten Chips (2) gekoppelt ist.

9. Integrierte Schaltung (3) nach dem vorhergehenden Anspruch, wobei das passive resistive Bauelement (9) in einem dritten Chip (90) ausgebildet ist, der mit dem zweiten Chip (2) über eine Drahtverbindung (5) elektrisch gekoppelt ist.

10. Integrierte Schaltung (3) nach Anspruch 9, wobei das passive resistive Bauelement (9) innerhalb des zweiten Chips (2) oder des ersten Chips (1) ausgebildet ist.

11. Integrierte Schaltung (3) nach Anspruch 9 oder 10, wobei das passive resistive Bauelement (9) einen Widerstand zwischen 100 Kilo-Ohm und 1 Mega-Ohm hat.

12. Integrierte Schaltung (3) nach einem der vorhergehenden Ansprüche, wobei der erste Chip eine Vielzahl von Chips (1, 1') enthält, die jeweils einen Hochspannungstransistor im Verarmungsmodus aufweisen und parallel zueinander geschaltet sind.

13. Integrierte Schaltung (3) nach dem vorhergehenden Anspruch, aufweisend eine Vielzahl von Drain-Pins (31, 31'), wobei jeder Drain-Pin elektrisch mit einem Drain-Kontaktpad (11, 11') eines Chips (1, 1') des ersten Chips gekoppelt ist.

## Claims

1. Integrated circuit (3) comprising a package (4) and a plurality of connection pins, a first chip (1) comprising a high voltage transistor in depletion mode, and comprising a second chip (2) comprising a low-voltage transistor in enhancement mode, the first and the second chip respectively comprising gate (13, 23), drain (11, 21) and source (12, 22) contact pads ; the source contact pad (12) of the high-voltage transistor being electrically coupled to the drain contact pad (21) of the low-voltage transistor to thus form a middle node of the circuit, the integrated circuit comprising a first kelvin pin (36) electrically coupled to the source contact pad (22) of the low voltage transistor, the integrated circuit comprising a middle point pin (35) electrically coupled to the middle node of the circuit, the integrated circuit further including a drain pin (31) electrically coupled to a drain contact pad (11) of the high-voltage transistor, a source pin (32) electrically coupled to the source contact pad (22) of the low voltage transistor, a gate pin (33) electrically coupled to the gate contact pad (23) of the low voltage transistor, the integrated circuit being **characterised in that** it further comprises a second kelvin pin (36') electrically coupled to the source contact pad (22) of the low voltage transistor.

2. Integrated circuit according to claim 1, wherein the first kelvin pin (36) is adjacent to the gate pin (33), or arranged on the same side of the package as the gate pin (33), and the second kelvin pin (36') is adjacent to the middle point pin (35), or arranged on the same side of the package (4) as the middle point pin (35).

3. Integrated circuit (3) according to claim 1 or 2, wherein the middle point pin (35) is adjacent to the source pin (32).

4. Integrated circuit (3) according to one of the preceding claims, comprising a second gate pin (37) electrically coupled to the gate contact pad (13) of the high voltage transistor.

5. Integrated circuit (3) according to the preceding claim, wherein the second gate pin (37) is adjacent to the middle point pin (35).

6. Integrated circuit (3) according to one of claims 1, 2, and 3, wherein the source contact pad (22) of the low voltage transistor is electrically coupled to the gate contact pad (13) of the high voltage transistor.

7. Integrated circuit (3) according to one of the preceding claims, wherein electrical coupling consists of wire connections (5).

8. Integrated circuit (3) according to one of the preceding claims, comprising a resistive passive component (9) arranged in the package (4) and electrically coupled between the gate contact pad (23) of the second chip (2) and the source contact pad (22) of the second chip (2).

9. Integrated circuit (3) according to the preceding claim, wherein the resistive passive component (9) is formed within a third chip (90) electrically coupled to the second chip (2) via wire connection (5).

10. Integrated circuit (3) according to claim 9, wherein the resistive passive component (9) is formed within the second chip (2) or the first chip (1).

11. Integrated circuit (3) according to claim 9 or 10, wherein the resistive passive component (9) has a resistance of between 100 kilo-ohms and 1 mega-ohm.

12. Integrated circuit (3) according to one of the preceding claims, wherein the first chip includes a plurality of chips (1, 1') each comprising a high voltage transistor in depletion mode, and parallelly connected to each other.

13. Integrated circuit (3) according to the preceding claim, comprising a plurality of drain pin (31, 31') each drain pin being electrically coupled to a drain contact pad (11, 11') of a chip (1, 1') of the first chip.
